# EUROPEAN PATENT APPLICATION

(11) **EP 3 912 818 A1**
(43) Date of publication of application: **24.11.2021**
(21) Application number: 20741662.9
(22) Date of filing: 16.01.2020
(51) Int. Cl.: B41F 15/34, B41F 27/12

(54) **PRINT SCREEN UNIT**

(30) Priority: 18.01.2019 KR 20190006934
(71) Applicant: Vontronics Co., Ltd., Anyang-si, Gyeonggi-do 14086 (KR)
(72) Inventor: CHOI, Soon-Von, Gunpo-si, Gyeonggi-do 15817 (KR)
(74) Representative: Cabinet Laurent & Charras
(86) International application number: PCT/KR2020/000759
(87) International publication number: WO 2020/149649

(57) **Abstract**

The printing screen unit according to the present invention includes a printing screen including engaging holes formed at regular intervals along an edge in a longitudinal direction and a pattern of printing apertures formed in a center, first and second pairs of interface parts fitted and coupled via a connecting member so as to face each pair of edge portions of the printing screen, and first to fourth corner pieces to connect each of the interface parts, the connecting member including a body that is horizontally seated on a seating portion formed on a lower surface of the interface parts, one or more first engaging protrusion that protrude in a center vertically from an upper surface of the body at regular intervals along the longitudinal direction of the body, and are inserted into and engaged with first engaging slots 44 formed on the seating portion at the same as they are respectively inserted into each of the engaging hole of the printing screen, and one or more second engaging protrusions that protrude at an outer end vertically from the upper surface of the body at regular intervals along the longitudinal direction of the body, and are inserted into and engaged with second engaging slots formed on the seating portion.

## Description

### [Technical Field]

The present invention relates to a printing screen unit, and more particularly, to a printing screen unit with an improved coupling structure of a printing screen, a connecting member, first and second pairs of interface parts, and first to fourth corner pieces.

### [Background Art]

Generally, a printing screen of a printing screen unit is made of a thin, stiff metallic material, such as stainless steel or brass, and includes a number of printing apertures forming a pattern that is used for printing of print media such as solder. The printing screen is mounted on a rectangular support frame for tensioning the printing screen by a flexible perforated sheet made of a mesh woven from polypropylene or stainless steel strand.

The printing screen is used while attached to the support frame, but if the printing screen is scratched with a squeegee, the printing pattern is misplaced or distorted due to slack present. In order to prevent such a situation, when performing screen printing, it is necessary to apply a tensile force to the printing screen so that the printing screen always has a predetermined tensile force.

Since the printing screen is often attached to the support frame using an adhesive, the printing screen is attached to the support frame when a printing screen is required. Therefore, when not in use, heavy and bulky printing screens have to be stored or transported.

There is a support frame to which a printing screen is attached by winding or clamping the edges of the printing screen. In the case of this support frame, the printing screen can be removed from the support frame for storage or transportation when the printing screen is not in use, but because the printing screen is thin, care must be taken to store or transport the printing screen without damaging the precisely formed print pattern.

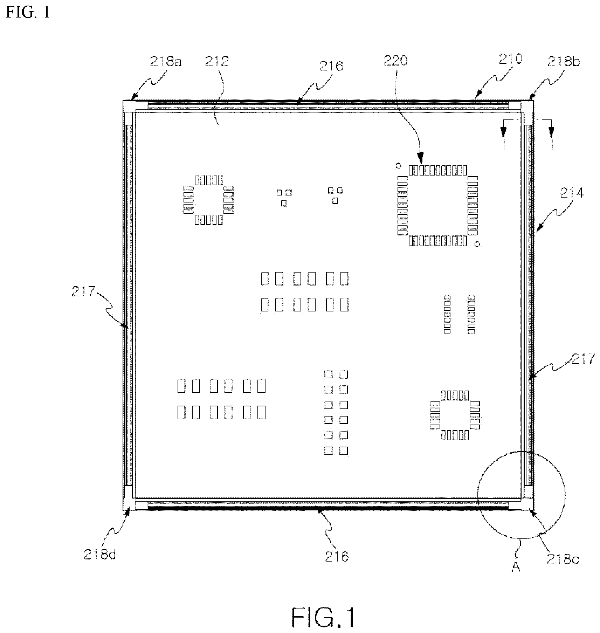

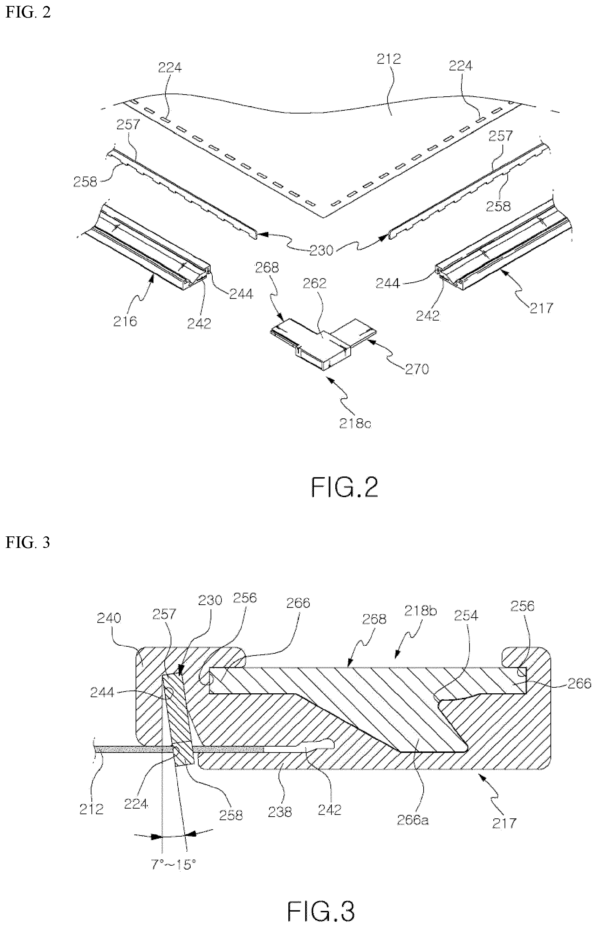

In view of this situation, a conventional printing screen unit 210 of Korean Patent Registration No. 10-1656022 (2016.09.02) proposed by the present applicant, as disclosed in FIGS. 1 to 3, includes a rectangular printing screen 212 having a printing aperture 220, first and second pairs of interface parts 216, 216, 217, 217 fitted and attached via a connecting member 230 so as to face each pair of edge portions of the printing screen 212, and first to fourth corner pieces 218a-218d connecting the respective interface parts 216, 216, 217, 217.

At the edge of the printing screen 212, an engaging hole 224 is repeatedly formed at a predetermined interval along the longitudinal direction so that it is oppositely engaged with the lower portion of the connecting member 230 and fitted to the first and second pairs of interface parts 216, 216, 217, 217, and the engaging hole 224 is preferably formed in a rectangular shape.

The first and second pairs of interface parts 216, 216, 217, 217 includes a lower body portion 238 having a first connecting slot 242 into which each edge of the printing screen 212 is fitted horizontally, and an upper body portion 240 having a second connecting slot 244 to which the vertically erected connecting member 230 is fitted.

The upper body portion 240 includes an engaging surface 254 that is formed at the inner lower end thereof while extending along the longitudinal direction of the first and second pairs of interface parts 216, 216, 217, 217 so as to provide engagement with a tension device (not shown), and a concave portion 256 that is formed on both sides of the inner upper end thereof while extending along the longitudinal direction of the first and second pair of interface parts 216, 216, 217, 217 so as to accommodate both orthogonal ends of the corner pieces 218a-218d.

The connecting member 230 is a rectangular long bar, and includes a long body 257 that is vertically erected and fitted to the second connecting slot 244 formed in the upper body portion 240 of the first and second pairs of interface parts 216,216,217,217, and an engaging protrusion 258 that is continuously formed at a regular interval along the longitudinal direction at the lower portion of the long body 257 and is oppositely engaged to the engaging hole 224 of the edge portion of the printing screen 212.

The corner pieces 218a-218d include first and second piece members 268 and 270 that are simultaneously fitted oppositely to the concave portion 256 at the end and the engaging surface 254 of the first and second pairs of interface parts 216, 216, 217, 217 to be orthogonally connected.

However, in the conventional printing screen unit 110 configured as described above, when each edge of the printing screen 212 and the first and second pairs of interface parts 216, 216, 217, 217 are fitted and coupled through the connecting member 230, the long body 257 of the connecting member 230 is vertically erected toward the second connecting slot 244 formed in the upper body portion 240 of the first and second pair of interface parts 216,216,217,217 and fitted by sliding sideways. and the engaging projection 258 of the connecting member 230 is engaged with the engaging hole 224 formed at the edge of the printing screen 212 and protrudes to an outside. Thus, when the printing screen unit 210 is attached to or detached from the tension device (not shown), an operator's hand touches the end (sharp part) of the engaging protrusion 258 of the connecting member 230 protruding to the lower portion of the printing screen 212, so that there may be discomfort of the touching and fear of injury. In addition, there is a disadvantage of penetrating of foreign substance or the like into the engaging hole 224, resulting in reducing quality.

In addition, since the first connecting slot 242 is formed horizontally in the lower body portion 238 of the first and second pairs of interface parts 216, 216, 217, 217 so that each edge of the printing screen 212 is inserted and fixed, mass production is difficult due to the manufacturing process of the narrow and long gap of the first connecting slot 242, as well as there are disadvantages of material waste, processing costs and time are excessive, resulting in high production costs.

In addition, the first and second piece members 268 and 270 protruding orthogonally from both sides of the first to fourth corner pieces 218a-218d are fitted and orthogonally connected or mounted on a tension device (not shown), and the concave portion 256 from which the engaging surface 254 protrudes is formed in the upper body portion 240 of the first and second pairs of interface parts 216, 216, 217, 217 so as to be engaged with a tensioning device (not shown) to apply tensile force. However, since the engaging surface 254 of this structure is formed from the starting point of the intermediate height of the concave portion 256, the area (depth) that contacts each other when the tension device (not shown) is engaged with the engaging surface 254 is small. As a result, there is a disadvantage in that the first and second pairs of the interface parts 216, 216, 217, and 217 cannot withstand the tensile force and are ruptured or deformed, thereby weakening the tensile force.

In addition, the first and second piece members 268 and 270 protrude from the body 262 of the first to fourth corner pieces 281a-218d so as to be orthogonal to two directions, and are fitted and connected to the first and second pairs of interface parts 216, 216, 217, 217. However, since the facing inner ends of the first piece member 268 and the second piece member 270 are formed at a right angle in order to contact with the body 262, when the printing screen 212 that is coupled to the first and second pair of interface parts 216, 216, 217, 217 via the connecting member 230 is commercialized as a printing screen unit 210 and moved and stored, torsion stress is generated by the physical action applied to the corner pieces 218a-218d. As a result, it not only fails to maintain the horizontality of the printing screen 212, but also causes the corner portion of the printing screen 212 to bend. By doing so, there is a disadvantage of lowering the quality of the printing screen unit 210.

### [Detailed Description of Invention]

### [Problem to be Solved]

An object of the present invention is proposed to solve the existing problems, and to provide a printing screen unit with improved quality capable of preventing in advance of discomfort and injury when an operator's hand comes in contact with the engaging protrusions (sharp areas) of a connecting member and at the same time preventing foreign substances from penetrating into the engaging holes of the printing screen, by improving the structure of the connecting member that connects each edge of the printing screen with the first and second pairs of interface parts.

Another object of the present invention is to provide a printing screen unit capable of increasing mass production and at the same time reducing material waste, processing cost and time, resulting in reducing production cost, by improving the coupling direction of each edge of a printing screen, first and second pairs of interface parts, and a connecting member.

Another object of the present invention is to provide a printing screen unit capable of preventing first and second pairs of interface parts from being ruptured or deformed in advance and simultaneously increasing a tensile force by widening the area (depth) in contact with a tension device (not shown).

Another object of the present invention is to provide a printing screen unit with improved quality capable of preventing torsion stress from being generated by a physical action applied to the printing screen unit by improving the structure of first to fourth corner pieces, and at the same time preventing the bending of the corner portions of the printing screen in advance while maintaining the horizontality of the printing screen.

### [Solution to Problem]

In order to solve the problem above, the printing screen unit according to the embodiment of the present invention includes a printing screen including engaging holes formed at regular intervals along an edge in a longitudinal direction and a pattern of printing apertures formed in a center, first and second pairs of interface parts fitted and coupled via a connecting member so as to face each pair of edge portions of the printing screen, and first to fourth corner pieces to connect each of the interface parts. The connecting member includes a body that is horizontally seated on a seating portion formed on a lower surface of the interface parts, one or more first engaging protrusion that protrude in a center vertically from an upper surface of the body at regular intervals along the longitudinal direction of the body, and are inserted into and engaged with first engaging slots formed on the seating portion at the same as they are respectively inserted into each of the engaging hole of the printing screen, and one or more second engaging protrusions that protrude at an outer end vertically from the upper surface of the body at regular intervals along the longitudinal direction of the body, and are inserted into and engaged with second engaging slots formed on the seating portion.

In another embodiment of the present invention, the connecting member is injection-molded with a polyacetal material.

In another embodiment of the present invention, the inner end of the body is formed in a shape that is bent upward while gradually increasing in a thickness toward the center of the body so as to be in close contact with a lower end of the printing screen.

In another embodiment, the concave portion having the engaging surface is formed at a center of an upper surface of the interface parts in a longitudinal direction, so that engagement with a tensioning device is provided or first and second piece members of the first to fourth corner pieces are respectively inserted to connect the interface parts as a square frame.

In another embodiment of the present invention, the engaging surface is formed from the upper surface of the interface parts to a bottom of the concave portion.

In another embodiment of the present invention, the first to fourth corner pieces includes a body, the first and second piece members that are formed orthogonally to two directions of the body and simultaneously fitted oppositely and coupled to the concave portion of the interface parts, and a torsion preventing piece formed at a right-angled corner of inner ends of the body facing each other to hold the first piece member and the second piece member from torsion.

In another embodiment of the present invention, an outline of the torsion preventing piece crossing between the first piece member and the second piece member in a diagonal direction is formed with a concave curvature so that torsion stress applied to the corner pieces is dispersed.

### [Advantageous Effects of Invention]

In the printing screen unit of the present invention, when each edge of the printing screen and the first and second pairs of interface parts are fitted and coupled through the connecting member, a plurality of first engaging protrusions and a plurality of second engaging protrusions formed at regular intervals on the body of the connecting member are directly fitted and coupled from an outside toward the first and second connecting slots formed at regular intervals on the lower seating portion of the interface parts, and thus, the plurality of first engaging protrusions of the connecting member are coupled to the first connecting slot by being engaged with and coupled to the engaging hole formed on the edge of the printing screen. Thus, it can prevent the engaging hole of the printing screen, the first and second engaging protrusions of the connecting member, and the first and second connecting slots of the interface parts from being exposed to the outside. As a result, there is an effect of improving the quality by preventing in advance the discomfort and injury of the operator's hand coming into contact with the engaging projection of the connecting member, and at the same time preventing the penetration of foreign substances into the engaging hole of the printing screen.

In addition, since the printing screen unit of the present invention has a structure that excludes slots in the interface parts so that each edge portion of the printing screen is inserted and fixed, the manufacturing process can be simplified, thereby increasing mass production capacity and at the same time there is an effect that can reduce the production cost by reducing material waste, processing cost and time.

In addition, in the printing screen unit of the present invention, since the engaging surface of the concave portion formed in the center of the upper surface of the interface parts is formed to match the height of the upper end of the interface parts, the area (depth) in contact with a tension device is increased as the height (starting point) from the bottom of the concave portion to the engaging surface is risen. According, when a tensile force is applied, the first and second pairs of interface parts can be prevented from being ruptured or deformed, and at the same time, there is an effect of increasing the tensile force.

In addition, the printing screen unit of the present invention has a torsion preventing piece formed to connect the right angle corner portions at the inner ends of the first piece member and the second piece member protruding from the body of the first to fourth corner pieces so as to be orthogonal to two directions. Thus, it is possible to prevent torsion stress applied to the corners of the corner piece, so that not only can the horizontality of the printing screen be maintained, but also the quality of the printing screen unit can be improved by preventing the bending of the corners of the printing screen in advance.

### [Brief Description of Drawings]

- FIG. 1: is a plan view showing a conventional printing screen unit.
- FIG. 2: is an exploded perspective view as seen from an area A in FIG. 1.
- FIG. 3: is a longitudinal cross-sectional view as viewed from a region I-I of FIG. 1.
- FIG. 4: is a plan perspective view showing a printing screen unit of the present invention.
- FIG. 5: is an exploded perspective view as seen from an area B in FIG. 4.
- FIG. 6: is a longitudinal cross-sectional view as viewed from a region II-II of FIG. 4.

***Explanation of main reference signals of drawings**

| | | | |
|---|---|---|---|
| 10 : | printing screen unit | 20 : | printing screen |
| 22 : | printing aperture | 24 : | engaging hole |
| 30 : | connecting member | 32 : | body |
| 34 : | first engaging protrusion | 34a | engaging jaw |
| 36 : | second engaging protrusion | 36a : | engaging jaw |
| 40 : | first pair of interface parts | 42 : | second pair of interface parts |
| 43 : | seating portion | 44 : | first connecting slot |
| 44a: | engaging jaw | 45 : | second connecting slot |
| 45a: | engaging jaw | 46 : | concave portion |
| 47 : | engaging surfac e | 50a-50d : | first to fourth corner pieces |
| 52 : | body | 54 : | first piece member |
| 56 : | second piece member | 58 : | torsion preventing piece |

### [Best Mode of embodiments]

In order to fully understand the present invention, preferred embodiments of the present invention will be described with reference to the accompanying drawings. The embodiments of the present invention may be modified in various forms, and the scope of the present invention should not be construed as being limited to the embodiments described in detail below. This embodiment is provided to more completely explain the present invention to those of ordinary skill in the art. Accordingly, the shape of elements in the drawings may be exaggerated to emphasize more clear description. It should be noted that in each drawing, the same configuration may be indicated by the same reference numeral. Detailed descriptions of known functions and configurations that are determined to unnecessarily obscure the subject matter of the present invention will be omitted.

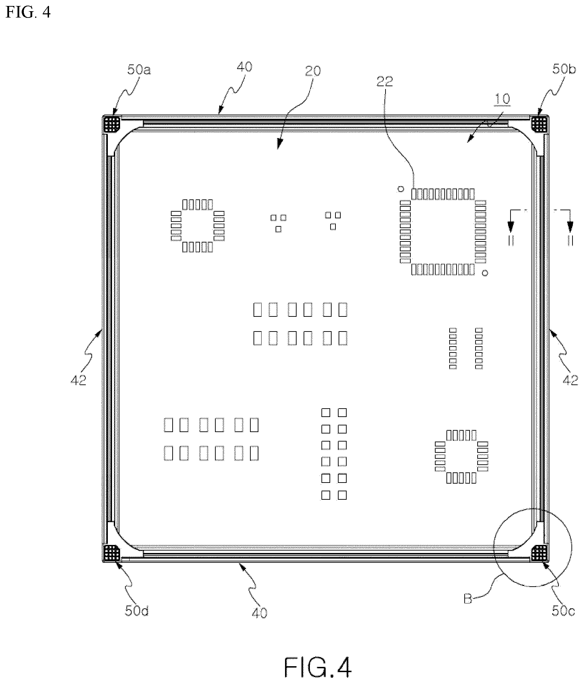

Hereinafter, an embodiment of the present invention will be described in detail with reference to FIGS. 4 to 6 of the accompanying drawings.

The printing screen unit 10 of the present invention includes a rectangular printing screen 20 having a pattern of a printing aperture 22, and first and second pairs of interface parts 40, 40, 42, 42 fitted and coupled via a connecting member 30 so as to face each pair of edge portions of the printing screen 20, and first to fourth corner pieces 50a-50d respectively connecting the interface parts 40, 40, 42, 42.

At the edge of the printing screen 20, an engaging hole is repeatedly formed at a regular interval in a longitudinal direction by being engaged oppositely to the lower portion of the connecting member 30 so as to be seated on a seating portion 43 of the first and second pairs of interface parts 40, 40, 42, 42. The engaging hole 24 may be preferably formed in a rectangular shape.

The connecting member 30 is in the form of a long strip injection-molded of a polyacetal material, and includes a body 32 horizontally seated on the seating portion 43 of the first and second pairs of interface parts 40, 40, 42, 42, one or more first engaging protrusions 34 having an engaging jaw 34a that protrude in a center vertically from an upper surface of the body 32 at a regular intervals along the longitudinal direction of the body 32, and are inserted into and elastically engaged with first engaging slots 44 formed on the seating portion 43 at the same as they are respectively inserted into each of the engaging holes 24 of the printing screen 20, and one or more second engaging protrusions 36 having an engaging jaw 36a that protrude at an outer end vertically from the upper surface of the body 32 at a regular intervals along the longitudinal direction of the body 32 and are inserted into and engaged with the second connecting slot 45 formed on the seating portion 43.

In this case, the inner end of the body 32 is preferably formed in a shape that is bent upward while gradually increasing in a thickness toward the center of the body 32 so as to be in close contact with the lower end of the printing screen 20.

Preferably, the engaging jaw 34a of the first engaging protrusion 34 and the engaging jaw 36a of the second engaging protrusion 36 are formed to be positioned in an outer direction opposite to each other.

Preferably, the first engaging protrusion 34 protrudes higher than the second engaging protrusion 36 so that the engaging jaws 34a and 36a protruding from the upper end thereof face outward opposite to each other.

The first and second pairs of interface parts 40, 40, 42, 42 include the seating portion 43 that is formed to be stepped along the longitudinal direction at the lower inner side and guides each edge of the printing screen 20 to be seated, the first connecting slot 44 having the engaging jaw 44a that is formed vertically along the longitudinal direction at the inner end of the seating portion 43 so that the plurality of first connecting slots 44 of the connecting member 30 are simultaneously fitted and coupled, a second connecting slot 45 having an engaging jaw 45a that is formed vertically along the longitudinal direction at the outer end of the seating portion 43 so that the plurality of second connecting slots 45 formed in the connecting member 30 is simultaneously fitted and coupled, and a concave portion 46 having an engaging surface 47 that is formed to be elongated along the longitudinal direction at the center of the upper surface in a longitudinal direction, so that engagement with a tensioning device (not shown) is provided or the first to fourth corner pieces 50a-50d are respectively inserted to connect the interface parts 40, 40, 42, 42 as a square frame.

In this case, the depth of the first connecting slot 44 is formed to be higher than the depth of the second connecting slot 45, and the engaging jaws 44a and 45a formed on the upper ends thereof are preferably formed to face outward opposite to each other.

The engaging surface 47 is formed from the upper surface of the interface parts 40, 40, 42, 42 to the bottom of the concave portion 46.

The first to fourth corner pieces 50a-50d includes a body 52 in a square shape, first and second piece members 54 and 56 that are formed to be orthogonal to the two directions of the body 52, and simultaneously fitted oppositely and coupled to the concave portions 46 of the first and second pairs of interface parts 40,40,42,42, and a torsion preventing piece 58 that is formed integrally at the right angle corners of the inner ends of the first piece member 54 and the second piece member 56 facing each other at the body so as to holds the first piece member 54 and the second piece member 56 from torsion.

In this case, the outline of the torsion preventing piece 58 crossing between the first piece member 54 and the second piece member 56 in a diagonal direction is preferably formed with a concave curvature so that torsion stress applied to the corner pieces 50a-50d is distributed.

Next, the operation and effect of the printing screen unit of the present invention configured as described above will be described.

The printing screen unit 10 of the present invention is assembled by forming a rectangular support frame by connecting the ends of the first and second pairs of interface parts 40, 40, 42, and 42 to the first to fourth corner pieces 50a-50d, and seating each edge portion of the printing screen 20 on the seating portion 43 formed on the lower surface of the first and second pairs of interface parts 40, 40, 42, 42 so that the each edge portion is in contact with the seating portion and then connecting the first and second pairs of interface parts 40, 40, 42 and 42 are each of the edge portions of the printing screen 20 by a plurality of connecting members 30.

In this case, the first piece member 54 and the second piece member 56 of the first to fourth corner pieces 50a-50d are respectively fitted and coupled to the concave portions 46 formed on the upper surfaces of the interface parts 40, 40, 42 and 42 so that the first and second pairs of interface parts 40, 40, 42, 42 form a right angle.

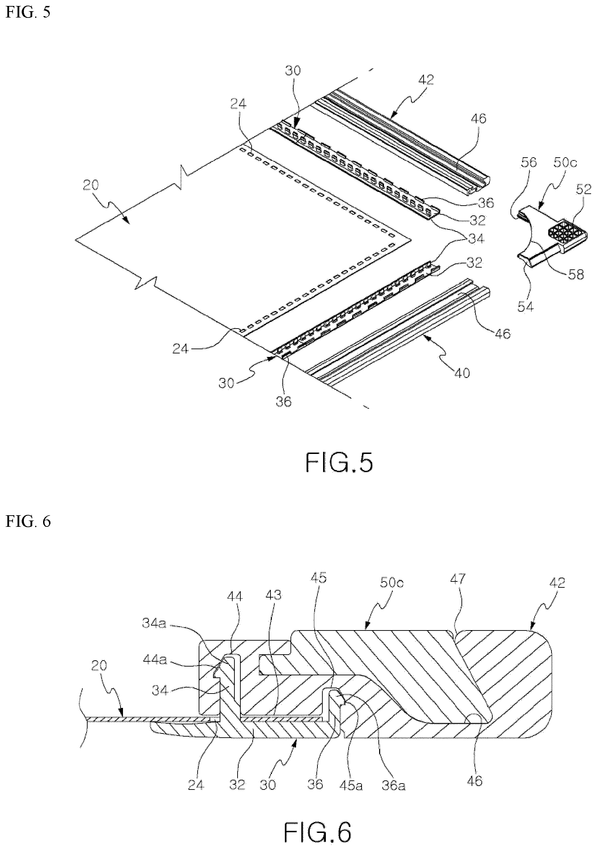

And, as shown in FIG. 6, a plurality of engaging holes 24 formed at each edge of the printing screen 20 and the first connecting slot 44 formed on the seating portion 43 of the lower surface of the first and second pairs of interface parts 40, 40, 42, 42 are matched, and then a plurality of the first engaging protrusion 34 and the second engaging protrusion protruding vertically at a certain distance from the upper surface of the connecting member 30 are inserted into and coupled to the first connecting slot 44 and the second connecting slot 45 formed on the seating portion 43 to be matched. As a result, each edge of the printing screen 20 is interposed and firmly fixed between the seating portion 43 of the first and second pairs of interface parts 40, 40, 42, 42 and the connecting member 30.

That is, the plurality of first engaging protrusions 34 of the connecting member 30 is inserted into the first connecting slots 44 formed on the seating portion 43 of the interface parts 40, 40, 42, 42 through the engaging holes 24 of the printing screen 20. Thus, the engaging jaws 44a formed on the upper ends of the first connecting slots 44 and the engaging jaws 34a formed on the upper end of the plurality of first engaging protrusions 34 are correspondingly engaged and fixedly coupled.

In addition, the plurality of second engaging protrusions 36 of the connecting member 30 are inserted into the second connecting slots 45 formed on the seating portion 43 of the interface parts 40, 40, 42, 42. Thus, the engaging jaws 45a formed on the upper ends of the connecting slots 45 and the engaging jaws 36a formed at the upper ends of the plurality of second engaging protrusions 36 are correspondingly engaged and firmly coupled.

In this case, when the plurality of first engaging protrusions 34 is coupled to the first connecting slots 44 of the interface parts 40, 40, 42, 42 through the engaging holes 24 of the printing screen 20, the connecting member 30 presses the edge portions of the printing screen 20 to give a first binding force to firmly adhere to the seating portion 43 of the interface parts 40, 40, 42, 42. When the plurality of second engaging protrusions 36 is coupled to the second connecting slots 45 of the interface parts 40, 40, 42, 42, the connecting member 30 presses the edge portions of the printing screen 20 to press the interface parts 40, 40, 42, 42 to provide a secondary binding force to firmly adhere to the seating portions 43 of the interface parts 40, 40, 42, 42.

Accordingly, in the present invention, when each edge of the printing screen 20 and the first and second pairs of interface parts 40, 40, 42, 42 are fitted and coupled through the connecting member 30, a plurality of first engaging protrusions 34 and a plurality of second engaging protrusions 36 formed at regular intervals on the body 32 of the connecting member 30 are directly fitted and coupled from an outside toward the first and second connecting slots 44, 45 formed at regular intervals on the lower seating portion 43 of the interface parts 40, 40, 42, 42, and thus, the plurality of first engaging protrusions 34 of the connecting member 30 are coupled to the first connecting slot 44 by being engaged with and coupled to the engaging hole 24 formed on the edge of the printing screen 20. Thus, it can prevent the engaging hole 24 of the printing screen 20, the first and second engaging protrusions 34, 36 of the connecting member 30, and the first and second connecting slots 44, 45 of the interface parts 40, 40, 42, 42 from being exposed to the outside. As a result, there is an effect of improving the quality by preventing in advance the discomfort and injury of the operator's hand coming into contact with the engaging projection 34, 36 of the connecting member 30, and at the same time preventing the penetration of foreign substances into the engaging hole 24 of the printing screen 20.

Since the present invention has a structure that excludes slots in the interface parts 40, 40, 42, 42 so that each edge portion of the printing screen 20 is inserted and fixed, the manufacturing process can be simplified, thereby increasing mass production capacity and at the same time there is an effect that can reduce the production cost by reducing material waste, processing cost and time.

In the present invention, since the engaging surface 47 of the concave portion 46 formed in the center of the upper surface of the interface parts 40, 40, 42, 42 is formed from the upper surface of the interface parts 40, 40, 42, 42 to the bottom of the concave portion 46, the area (depth) in contact with a tension device (not shown) can be increased. According, when a tensile force is applied, the first and second pairs of interface parts 40, 40, 42, 42 can be prevented from being ruptured or deformed, and at the same time, there is an effect of increasing the tensile force.

The present invention has a torsion preventing piece 58 formed to connect the right angle corner portions at the inner ends of the first piece member 54 and the second piece member 56 protruding from the body 52 of the first to fourth corner pieces 50a-50d so as to be orthogonal to two directions. Thus, it is possible to prevent torsion stress applied to the corners of the corner piece 50a-50d, so that not only can the horizontality of the printing screen 20 be maintained, but also the quality of the printing screen unit 10 can be improved by preventing the bending of the corners of the printing screen 20 in advance.

On the other hand, the present invention is not limited to the above-described embodiments, but can be changed and modified within the scope not departing from the gist of the present invention, and the technical idea to which such changes and modifications are applied also fall within the scope of the following claims.

## Claims

1. A printing screen unit, comprising:
a printing screen 20 including engaging holes 24 formed at regular intervals along an edge in a longitudinal direction and a pattern of printing apertures 22 formed in a center, first and second pairs of interface parts 40, 40, 42, 42 fitted and coupled via a connecting member so as to face each pair of edge portions of the printing screen 20, and first to fourth corner pieces 50a-50d to connect each of the interface parts 40, 40, 42, 42,
wherein the connecting member 30 includes:
a body 32 that is horizontally seated on a seating portion 43 formed on a lower surface of the interface parts 40, 40, 42, 42;
one or more first engaging protrusion 34 that protrude in a center vertically from an upper surface of the body at regular intervals along the longitudinal direction of the body 32, and are inserted into and engaged with first engaging slots 44 formed on the seating portion 43 at the same as they are respectively inserted into each of the engaging hole 24 of the printing screen 20; and
one or more second engaging protrusions 36 that protrude at an outer end vertically from the upper surface of the body 32 at regular intervals along the longitudinal direction of the body 32, and are inserted into and engaged with second connecting slots 45 formed on the seating portion 43.

2. The printing screen unit according to claim 1, wherein the connecting member 30 is injection-molded with a polyacetal material.

3. The printing screen unit according to claim 1, wherein an inner end of the body 32 is formed in a shape that is bent upward while gradually increasing in a thickness toward the center of the body 32 so as to be in close contact with a lower end of the printing screen 20.

4. The printing screen unit according to claim 1, wherein a concave portion 46 having an engaging surface 47 is formed at a center of an upper surface of the interface parts 40, 40, 42, 42 in a longitudinal direction, so that engagement with a tensioning device is provided or first and second piece members 54, 56 of the first to fourth corner pieces 50a-50d are respectively inserted to connect the interface parts 40, 40, 42, 42 as a square frame.

5. The printing screen unit according to claim 4, wherein the engaging surface 47 is formed from the upper surface of the interface parts 40, 40, 42, 42 to a bottom of the concave portion 46.

6. The printing screen unit according to claim 4, wherein the first to fourth corner pieces 50a-50d includes:
a body 52;
the first and second piece members 54, 56 that are formed orthogonally to two directions of the body 52 and simultaneously fitted oppositely and coupled to the concave portion 46 of the interface parts 40, 40, 42, and 42; and
a torsion preventing piece 58 that is formed at a right-angled corner of inner ends of the first piece member 54 and the second piece member 56 facing each other at the body 52 to hold the first piece member 54 and the second piece member 56 from torsion.

7. The printing screen unit according to claim 6, wherein an outline of the torsion preventing piece 58 crossing between the first piece member 54 and the second piece member 56 in a diagonal direction is formed with a concave curvature so that torsion stress applied to the first to fourth corner pieces 50a-50d is dispersed.
